# FASCICULE DE BREVET EUROPEEN

(11) **EP 3 513 117 B1**
(45) Date de publication et mention de la délivrance du brevet: **15.05.2024**
(21) Numéro de dépôt: 17758802.7
(22) Date de dépôt: 26.07.2017
(51) Int. Cl.: H04N 9/31, F21S 41/00, B60Q 1/04

(54) **DISPOSITIF LUMINEUX UTILISANT UNE SOURCE LUMINEUSE DE HAUTE RÉSOLUTION ET PROCÉDÉ POUR ILLUMINER UNE SCÈNE AVEC LEDIT DISPOSITIF**
BELEUCHTUNGSVORRICHTUNG MIT VERWENDUNG EINER HOCHAUFLÖSENDEN LICHTQUELLE UND VERFAHREN ZUR BELEUCHTUNG EINER SZENE MIT BESAGTER VORRICHTUNG
LIGHT DEVICE USING A HIGH-RESOLUTION LIGHT SOURCE AND METHOD FOR ILLUMINATING A SCENE WITH SAID DEVICE

(30) Priorité: 15.09.2016 FR 1658652
(43) Date de publication de la demande: 24.07.2019
(73) Titulaire: Valeo Vision, 93012 Bobigny Cedex (FR)
(72) Inventeur: AMIEL, François-Xavier, 93012 Bobigny Cedex (FR); DUBOIS, Vincent, 93012 Bobigny Cedex (FR); HOANG, Van-Thai, 93012 Bobigny Cedex (FR); CANONNE, Thomas, 93012 Bobigny Cedex (FR); MBATA, Samira, 93012 Bobigny Cedex (FR); THIN, Guillaume, 93012 Bobigny Cedex (FR); LEFAUDEUX, Nicolas, 93012 Bobigny Cedex (FR); DE LAMBERTERIE, Antoine, 93012 Bobigny Cedex (FR)
(74) Mandataire: Valeo Visibility
(86) Numéro de dépôt international: PCT/EP2017/068935
(87) Numéro de publication internationale: WO 2018/050338

(56) Documents cités:
- EP-A1- 2 380 774
- US-A1- 2014 219 506
- US-A1- 2015 085 507
- Texas Instruments: "TPS92661-Q1: High-Brightness LED Matrix Manager for Automotive Headlight Systems", , 1 février 2016 (2016-02-01), pages 1-53, XP055348745, Dallas, Texas Extrait de l'Internet: URL:http://www.ti.com/lit/ds/symlink/tps92 661-q1.pdf [extrait le 2017-02-22]

## Description

### DOMAINE DE L'INVENTION

L'invention se rapporte au domaine des dispositifs lumineux de véhicule terrestre, c'est-à-dire des dispositifs permettant, lors de l'utilisation du véhicule, de projeter de la lumière éclairant la route ou l'habitacle et/ou permettant au véhicule de se rendre plus visible. Des exemples de tels dispositifs lumineux sont les feux de position ou les feux de croisement et/ou route (communément appelés « phares »).

### ARRIERE-PLAN

Un véhicule terrestre est équipé de dispositifs lumineux, notamment d'éclairage et/ou de signalisation, tels que des projecteurs avants ou feux arrières, destinés à illuminer la route devant le véhicule, la nuit ou en cas de luminosité réduite. Ils peuvent aussi servir à éclairer l'habitacle du véhicule. Ces dispositifs lumineux peuvent comprendre un ou plusieurs modules lumineux. Chaque fonction d'éclairage peut être assurée par un ou des module(s).

Dans ces modules lumineux de véhicules terrestres, des sources électroluminescentes de lumière sont de plus en plus fréquemment utilisées, par exemple des sources lumineuses à état solide (acronyme de l'anglais « solid-state lighting »). Ces sources lumineuses peuvent être constituées par des diodes électroluminescentes ou LEDs (acronyme anglais pour « Light Emitting Diode »), par des diodes électroluminescentes organiques ou OLEDs (acronymes anglais pour « organic light-emitting diodes », ou encore par des diodes électroluminescentes polymériques ou PLED (acronymes anglais pour « polymer light-emitting diodes »). Ces sources lumineuses offrent notamment des avantages d'encombrement et de durée de vie par rapport à des sources de lumière classiques telles que par exemple les ampoules à filament.

En outre, on connaît des sources électroluminescentes de lumière à haute densité de pixels, aussi connues sous le nom de matrices monolithique de LEDs (ou encore monolithic array of LEDs en anglais). Dans ce contexte, les DELs sont également appelées pixels. Ces sources de lumière haute densité permettent de sélectionner avec une très grande précisions quelles sont les zones d'une scène qui sont éclairées, et avec quelle intensité lumineuse. Une matrice monolithique comprend plusieurs milliers de DELs qui sont situées sur un même substrat, les DELs étant séparées des autres par des lignes (ou encore « lanes » en anglais) ou des rues (ou encore « streets » en anglais). Chacune des DELs est indépendante électriquement des autres et éclaire donc de manière autonome des autres DEL de la matrice.

Afin de pouvoir tirer avantage de ces sources lumineuses à haute densité de pixels, par exemple pour implémenter des fonctions anti-éblouissement, il est nécessaire de pouvoir commander individuellement les éléments électroluminescents (les pixels) qui composent la matrice monolithique. Or, il n'existe aujourd'hui pas d'architecture permettant de piloter des sources lumineuses à haute densité de pixels.

EP 2 380 774 A1 décrit un projecteur comprenant une pluralité de sources lumineuses arrangées selon une matrice, une unité de contrôle des sources lumineuses et des capteurs environnementaux et une caméra permettant de capter l'environnement du véhicule afin que l'unité de contrôle adapte la commande qu'elle envoie aux sources lumineuses pour adapter le faisceau lumineux produit par les sources lumineuses.

US 2015/085507 A1 décrit un projecteur comprenant une matrice d'émetteurs lumineux, un miroir et/ ou une lentille pour mettre en forme la distribution lumineuse et une unité de contrôle pour contrôler les émetteurs. De plus, le projecteur comprend également des capteurs et une caméra qui fournissent des informations sur l'environnement et sur les paramètres physiques du véhicule qui permettent à l'unité de contrôle de contrôler les émetteurs en fonction de ces informations.

US 2014/219506 A1 décrit un procédé de transmission de données concernant l'environnement d'un véhicule à une unité de commande des phares de ce véhicule, les données ayant été prises à l'aide d'une caméra et/ou, le cas échéant, à l'aide de systèmes de capteurs environnementaux supplémentaires, pour vérifier la plausibilité des données.

La fiche technique du composant Texas Instrument TPS92661-Q1 "High-Brightness LED Matrix Manager for Automotive Headlight Systems" retrouvée à l'adresse http://www.ti.com/lit/ds/symlink/tps92661-q1.pdf décrit un pilote de matrice de LED.

### RESUME DE L'INVENTION

On propose pour cela un dispositif lumineux de véhicule terrestre pour éclairer une scène selon la revendication 1.

On propose également un procédé pour illuminer une scène avec le dispositif lumineux ci-dessus selon la revendication 11.

Les revendications dépendantes définissent des modes de réalisation avantageux.

### BREVE DESCRIPTION DES FIGURES

Différents modes de réalisation de l'invention vont maintenant être décrits, à titre d'exemples nullement limitatifs, en se référant aux dessins annexés dans lesquels :
- La FIG. 1 représente schématiquement un premier exemple de module lumineux pouvant être utilisé dans le dispositif lumineux selon l'invention ;
- La FIG. 2 représente schématiquement un deuxième exemple de module lumineux pouvant être utilisé dans le dispositif lumineux selon l'invention;
- La FIG. 3 montre schématiquement un exemple de dispositif lumineux selon l'invention ;
- La FIG. 4 montre un organigramme d'un exemple de procédé pour illuminer une scène selon l'invention.

### DESCRIPTION DETAILLEE

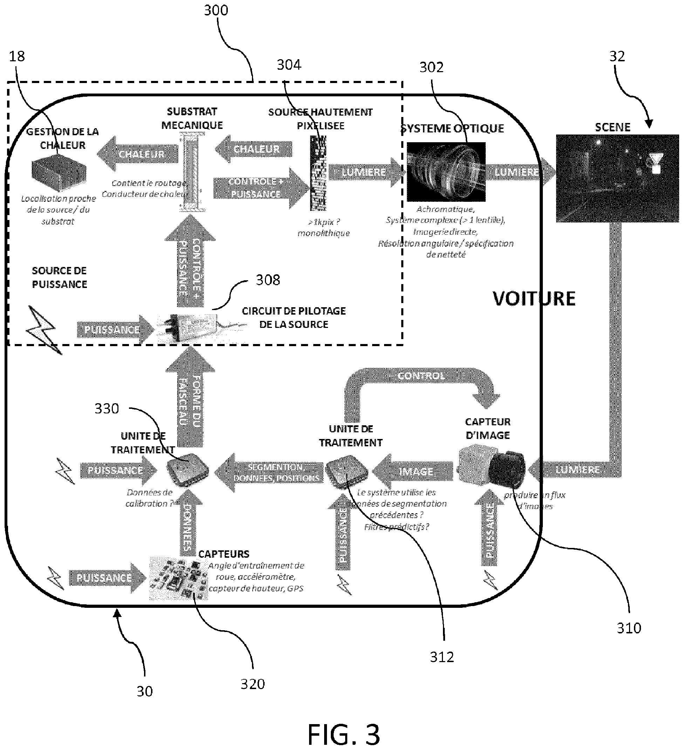

La figure 3 montre un exemple de dispositif lumineux 30 selon l'invention. Le dispositif lumineux peut être compris dans un véhicule terrestre afin d'éclairer une scène 32 qui est le volume de l'espace devant être éclairé, par exemple une route.

Le dispositif lumineux 30 comprend une source électroluminescente monolithique qui est une source de lumière à état solide (acronyme de l'anglais « solid-state lighting ») qui comprend un nombre élevé d'éléments électroluminescents ; typiquement, ce nombre est supérieur à 1000 éléments électroluminescents. Un élément électroluminescent peut être, mais n'est pas limité à, une diode électroluminescente (LED), une diode électroluminescente organique (OLED), une diode électroluminescente polymérique (PLED). La source électroluminescente est donc une lumineuse à semi-conducteur et elle comporte un substrat sur lequel sont placés les éléments électroluminescents. Un élément électroluminescent est plus généralement appelé pixel. Par conséquent, la source lumineuse comprend une pluralité de pixels déposés sur ou s'étendant à partir de la première face du substrat.

Les éléments électroluminescents peuvent être chacun semi-conducteur, c'est-à-dire qu'ils comportent chacun au moins un matériau semi-conducteur. Les éléments électroluminescents peuvent être majoritairement en matériau semi-conducteur. Ce matériau semi-conducteur peut être le même que ou différent du matériau du substrat. Les éléments électroluminescents peuvent plus généralement être tous réalisés dans le ou les mêmes matériaux. Les éléments électroluminescents peuvent être de même nature, par exemple sensiblement identiques ou similaires. Tous les éléments électroluminescents peuvent être positionnés pour former un motif régulier, par exemple une grille.

Les éléments sont électroluminescents. Cela signifie qu'ils émettent de la lumière lorsque le matériau des éléments électroluminescents est alimenté en électricité. Les éléments électroluminescents utilisent l'électroluminescence pour émettre de la lumière. L'électroluminescence est un phénomène optique et électrique durant lequel un matériau émet de la lumière en réponse à un courant électrique qui le traverse, ou à un fort champ électrique. Cela est à distinguer de l'émission de lumière en raison de la température (incandescence) ou de l'action des produits chimiques (chimiluminescence). On peut parler de pixel allumé lorsqu'un élément électroluminescent émet de la lumière.

La source électroluminescente est une source électroluminescente monolithique, encore appelée source de lumière à état solide à haute densité de pixels. Une matrice monolithique comprend des centaines ou des milliers d'élément électroluminescents qui sont situées sur un même substrat, et de préférence sur une même face du substrat qui peut être par exemple du saphir. Les DELs de la matrice monolithique sont séparées les unes des autres par des lignes (nommée « lanes » en anglais ou des rues (nommées « streets » en anglais). La matrice monolithique est donc une grille d'éléments électroluminescents ou encore une grille de pixels. Les éléments électroluminescents peuvent être des DELs, on parle dans ce cas de matrice monolithique d'éléments électroluminescents de LEDs qui est la traduction du terme anglais « monolithic array of LEDs ». Toute autre technologie peut être envisagée comme par exemple des diodes électroluminescentes organiques (OLEDs), des diodes électroluminescentes polymériques (PLEDs),...

La source électroluminescente monolithique est une source à haute densité, c'est-à-dire qu'elle comprend un nombre très important d'éléments électroluminescents, au moins plusieurs centaines d'éléments électroluminescents. En pratique, la source comporte plus de 500 éléments électroluminescents sur le même substrat. La densité de pixel est de préférence supérieure à 500 pixels par cm². Elle est typiquement comprise entre 500 et 2500 pixels par cm². On comprend que la densité de pixels d'une source lumineuse à haute densité d'éléments lumineux peut être supérieure à 2500 pixels par cm².

Chacun des éléments électroluminescents de la matrice est indépendant électriquement des autres et émet ou non de la lumière indépendamment des autres éléments de la matrice. Chaque élément de la matrice est commandé individuellement par un circuit électronique appelé « driver » en anglais. Le driver gère l'alimentation électrique de la matrice monolithique, ce qui revient à dire qu'il gère individuellement l'alimentation électrique de chaque élément électroluminescent. Alternativement, des éléments électroluminescents peuvent être regroupés électriquement, par exemple en les alimentant électriquement à l'aide d'un montage en parallèle ou en série, afin de diminuer le nombre d'éléments à gérer. Par exemple, les groupes peuvent comprendre entre deux et quatre éléments électroluminescents, ce nombre permettant de conserver un faisceau lumineux suffisamment pixélisé. Le driver est donc un dispositif électronique qui est apte à commander les éléments d'une matrice monolithique d'éléments électroluminescents. Plusieurs drivers peuvent être utilisés pour piloter les éléments électroluminescents de la matrice.

La source électroluminescente monolithique peut être comprise dans un module lumineux 300. On comprend que le module lumineux peut avoir plusieurs sources électroluminescentes monolithiques. Plusieurs modules lumineux comprenant une telle source électroluminescente monolithique peuvent être intégrés au dispositif lumineux selon l'invention. Le terme « module lumineux » désigne donc au moins une source électroluminescente monolithique.

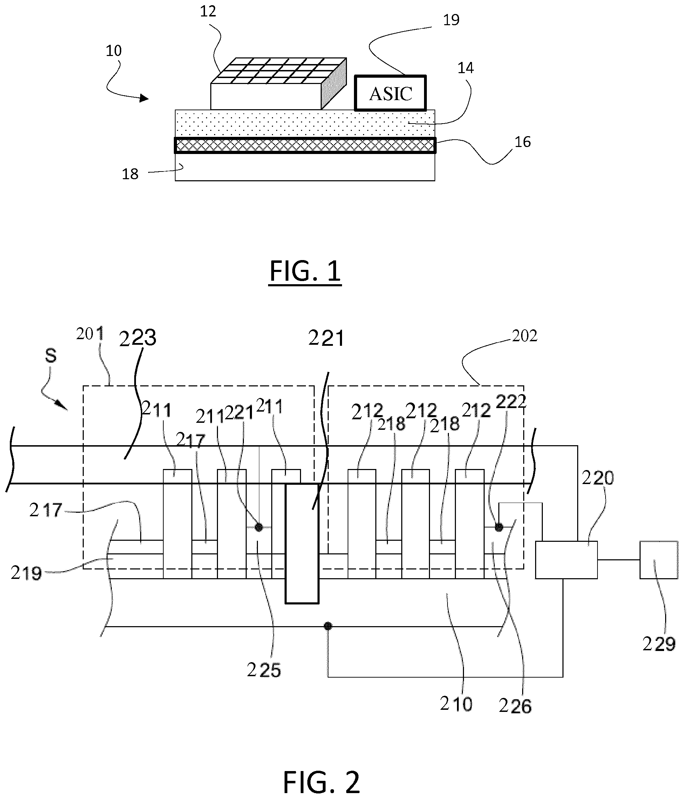

La FIG. 1 montre schématiquement un exemple d'un module lumineux. Le module lumineux 10 pour véhicule automobile comprend une source électroluminescente monolithique 12, par exemple une matrice de LEDs, un PCB 14 (acronyme de « Printed Circuit Board » en anglais, « circuit imprimé » en français) qui supporte la source 12 et le dispositif 19 commande les éléments électroluminescents de la source monolithique lumineuse 12. Tout autre support qu'un PCB peut être envisagé. Le module lumineux peut en outre comprendre au moins un dissipateur thermique 18 qui est peut être agencé directement ou indirectement sur la source 12. Dans cet exemple, le dissipateur thermique 18 est agencé indirectement sur la source puisque le PCB 14 et une interface thermique 16 sont situés entre le dissipateur thermique 18 et la source 12. Le dissipateur thermique permet le transfert de la chaleur de la source électroluminescente que cette dernière transmet au PCB lors de l'utilisation d'un module lumineux. Le dissipateur thermique permet une dissipation de chaleur via une coopération avec le support 14 de la source électroluminescente monolithique, c'est-à-dire que le dissipateur thermique reçoit la chaleur produite par la source électroluminescente. Le dissipateur thermique 18 est ainsi en communication de chaleur avec le PCB 14 qui est lui-même en communication de chaleur la source 12. La transmission peut être assurée par le fait que le dissipateur thermique est dans un exemple agencé directement contre le PCB 14. Cela signifie que le dissipateur thermique est en contact physique (i. e. de matériau) avec le PCB. Le dissipateur thermique 18 peut toutefois être alternativement agencé sur l'interposeur via un élément intermédiaire qui améliore le transfert thermique. Cet élément intermédiaire est aussi appelé interface thermique 16. L'élément intermédiaire 16 peut comprendre par exemple de la pâte thermique ou un matériau à changement de phase. L'élément intermédiaire peut comprendre du cuivre, par exemple l'interface thermique 16 est une plaque de cuivre. Ainsi, le module lumineux dissipe efficacement la chaleur.

Un deuxième exemple de module lumineux est discuté qui comprend une source électroluminescente monolithique dite « 3D », c'est-à-dire que les éléments électroluminescents ne sont pas uniquement déposés sur le substrat de la source : ils s'étendant à partir du substrat de la source. Le module lumineux comprend un grand nombre de sources électroluminescentes à semi-conducteur comportant un substrat majoritairement en matériau semi-conducteur. On peut ainsi faire référence au substrat par l'expression « substrat semi-conducteur ». Le substrat peut comporter un ou plusieurs autres matériaux, par exemple non semiconducteurs. Par conséquent, le module lumineux comprend au moins une pluralité de tels éléments s'étendant à partir de la première face du substrat. Les éléments peuvent être regroupés en un ou plusieurs ensembles. Chaque ensemble est constitué de plusieurs éléments s'étendant à partir d'une portion respective de la première face du substrat. Les éléments électroluminescents peuvent donc être répartis dans différentes zones d'émission lumineuse. Dans un exemple, ces différentes zones peuvent être activables sélectivement. Les éléments peuvent présenter une forme générale de bâtonnet et être ainsi appelés « bâtonnets ». Les éléments électroluminescents peuvent être alimentés en électricité via le substrat d'un côté (e. g. le substrat formant par exemple la cathode) et via une couche de matériau électriquement conducteur qui lie électriquement les éléments électroluminescents entre eux de l'autre côté (e. g. la couche de matériau électriquement conducteur formant par exemple l'anode). Le contact entre le matériau semi-conducteur de chaque élément électroluminescent et le matériau semi-conducteur du substrat peut donc être adapté à une conduction électrique. La couche de matériau électriquement conducteur peut recouvrir les éléments électroluminescents. La couche de matériau électriquement conducteur peut également recouvrir chaque portion de surface du substrat à partir de laquelle les éléments électroluminescents s'étendent, ou toute une surface ou face du substrat à partir de laquelle les ensembles d'éléments électroluminescents s'étendent. La couche de matériau électriquement conducteur peut être isolée électriquement du matériau semi-conducteur du substrat par tout moyen. Cela permet d'alimenter les éléments électroluminescents en électricité par le substrat. Ainsi, on peut alimenter les éléments électroluminescents en électricité simplement, c'est-à-dire en alimentant le matériau conducteur du substrat avec une polarité et la couche de matériau électriquement conducteur avec l'autre polarité.

Toujours dans ce deuxième exemple, la source électroluminescente peut être fabriquée par un procédé comprenant au moins une étape de fourniture du substrat, puis une étape de formation intégrale des bâtonnets avec le substrat, par croissance à partir du substrat. La couche de matériau électriquement conducteur peut être réalisée par une étape de dépose d'une finition métal, par exemple de cuivre pour assurer le pilotage des bâtonnets. Cette étape peut également comprendre la création de pads en aluminium ou cuivre sur une face du substrat, aptes à du câblage par fil entre la source et le composant de pilotage. Le câblage par fil ou « pontage » (également appelé « wirebonding » ou « wire bonding » de l'anglais ou encore « ribbon bonding »...) est une des techniques utilisées pour effectuer les connexions électriques entre la source électroluminescente et le dispositif d'alimentation de la source. Le câblage est simplement réalisé par un fil (ou pont) soudé entre les deux plots de connexion prévus à cet usage sur chacun des éléments. La soudure peut être réalisée par ultrasons. Le matériau du fil peut être de l'aluminium, de l'or ou du cuivre. Le diamètre du fil peut être de l'ordre de 20 µm. Un fil de section rectangulaire peut aussi être utilisé.

La FIG. 2 présente un exemple d'une telle source lumineuse électroluminescente monolithique dite « 3D ». La source lumineuse S, ici représentée en coupe, comprend un substrat 210 à partir duquel s'étendent selon une direction privilégiée des bâtonnets 211, 212. Ce substrat 210 est, notamment dans cet exemple, du silicium, ce qui représente un coût bien moindre à celui des LEDs classiques, dans lesquelles les substrats sont en saphir. Les bâtonnets 211, 212, peuvent être obtenus par croissance cristalline sur ce substrat 210.

Les bâtonnets 211, 212, sont agencés de manière à former des bâtonnets en un matériau semi-conducteur électroluminescent. Les bâtonnets 211, 212, peuvent par exemple être formés essentiellement de nitrure de gallium.

Par exemple, ces bâtonnets 211, 212, comprennent une âme en matériau semi-conducteur apte à être dopé en électrons, autour de laquelle est formée une première couche en matériau semi-conducteur apte à présenter des déficits en électrons, dans ce cas on parle parfois de couche dopé en « trous » ou en charges positives. A l'interface de cette âme et de cette première couche, se forme une couche intermédiaire où se recombinent les électrons et les déficits en électrons. Ainsi, chaque bâtonnet 211, 212, est un élément semi-conducteur électroluminescent.

Une couche de nucléation 219 est formée sur le substrat 210 et autour des bâtonnets 211, 212.

Les bâtonnets 211, 212, sont dans cet exemple distants d'environ 30 µm et ont chacun une hauteur, prise depuis la couche de nucléation 219 jusqu'à leur sommet, de 2,5 µm. Leur diamètre est de 1,5 µm. On comprend que ces valeurs sont données à titre indicatif et peuvent varier.

La source lumineuse S comprend donc essentiellement un substrat 210 formant une plaque hérissée d'une multitude de petits bâtonnets 211, 212, électroluminescents et submillimétriques, à savoir dont la plus grande dimension est inférieure au millimètre.

La source lumineuse S est divisée en plusieurs zones lumineuses 201, 202 séparées par des murets 221, correspondant à une répartition de l'ensemble des bâtonnets 211, 212.

Entre chaque bâtonnet 211, 212 d'une même zone 201, 202 est déposée une couche électriquement conductrice, joignant électriquement ces bâtonnets, formant ainsi une anode distincte 225, 226, pour chacune des zones lumineuses 201, 202.

Les quatre anodes 225, 226, ainsi formées sont en contact avec la couche de nucléation 219, qui elle-même est en contact avec la cathode formée par le substrat 210.

Ainsi, en connectant les anodes 225, 226 et la cathode 210 à une source d'alimentation, on peut alimenter en électricité indépendamment chacune des différentes zones lumineuses 201, 202.

Selon une réalisation, chaque anode est connectée à une ou plusieurs bornes positives d'un moyen de connexion 220, destiné à être connectée à la borne positive d'une source d'alimentation électrique (non représentée) d'un véhicule. De même, la cathode 210 est connectée à la borne négative du moyen de connexion 220. Le moyen d'activation permet donc l'alimentation électrique de chacune de ces zones lumineuses 201, 202.

Il est donc possible de piloter cette source lumineuse S, par activation sélective de ses zones lumineuses 201, 202, via le moyen d'activation 220.

Le pilotage peut être réalisé par un moyen spécifique distinct du dispositif lumineux, ou bien, comme dans cet exemple réalisé par un dispositif de pilotage 229 intégré au dispositif lumineux.

Dans cet exemple, le pilotage est réalisé directement par un dispositif de pilotage 229. Ce dernier est relié d'une part au moyen de connexion 220 et d'autre part au connecteur C. le moyen de connexion 220 est lui relié à chaque anode 225, 226, via des conducteurs électriques.

Le dispositif de pilotage 229 et la source lumineuse S sont montés sur une même carte de circuit imprimé, non représentée. Les conducteurs électriques sont formés par des pistes électroniques de cette carte de circuit imprimé. De même, d'autres pistes électroniques relient le moyen de connexion 220 au dispositif de pilotage 229.

Le rendement lumineux des zones lumineuses 201, 202peut être amélioré en déposant une couche réfléchissante 217, 218, sur la couche de nucléation 219. Cette couche réfléchissante 217, 218, est par exemple déposée sur la couche de nucléation 219 avant croissance des bâtonnets, puis des trous sont ménagés dans cette couche réfléchissante 217, 218, ainsi que dans la couche de nucléation, avant croissance des bâtonnets 211, 212, 213, 214, sur le substrat 10.

Pour avoir un meilleur rendement lumineux, les bâtonnets des zones lumineuses peuvent avoir les caractéristiques ci-dessous :
- un diamètre compris entre 1,4 µm et 1,6 µm, par exemple 1 µm,
- une hauteur comprise entre 2 µm et 10 µm, par exemple 8 µm,
- une distance entre chaque bâtonnet comprise entre 3 et 10 µm.

La source lumineuse S peut comprendre un convertisseur de lumière 223 agencé au-dessus des bâtonnets 211, 212. Un convertisseur de lumière comprend au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation. Le matériau peut par exemple être du YAG dopé au Cérium ou à l'europium.

Toujours dans l'exemple de la figure 2, la source lumineuse comprend est une source à haute densité, c'est-à-dire qu'elle comprend un nombre très important d'ensembles d'éléments électroluminescents, au moins plusieurs centaines d'ensembles d'éléments électroluminescents.

Le dispositif lumineux selon l'invention comprend également un système optique 302 qui est agencé pour former une image de la source électroluminescente monolithique. L'image peut être une image réelle ou bien encore une image virtuelle. Le système optique est donc placé en aval de la source électroluminescente monolithique dans le sens de parcours de la lumière émise.

Le système optique peut comprendre une optique de mise en forme, c'est-à-dire qu'au moins un des rayons émis par la source lumineuse est dévié par l'optique de mise en forme. Le terme « dévié » signifie que la direction d'entrée du rayon lumineux dans l'optique de mise en forme est différente de la direction de sortie du rayon lumineux de l'optique de mise en forme. Le système optique comprend au moins un élément optique tel qu'une ou plusieurs lentilles, un ou plusieurs réflecteurs, un ou plusieurs guides de lumière ou une combinaison de ces possibilités.

Sur la figure 3, le système optique 302 n'est pas compris dans le module lumineux 300. Cela permet de conserver le système optique lorsque le module lumineux est défectueux. On comprend que le système pourrait être compris dans le module lumineux 300. Le système optique peut avoir une résolution qui est inférieure ou égale à 0.25 degrés et un champ supérieur ou égale à 5 degré.

Le dispositif lumineux selon l'invention comprend un (ou plusieurs) dispositif(s) électronique(s) 330 apte(s) à commander les éléments électroluminescents de la source électroluminescente. Un tel dispositif électronique peut être par exemple un circuit intégré ou un convertisseur de puissance.

Un convertisseur de puissance est un dispositif de conversion d'une alimentation électrique issue d'un réseau d'alimentation électrique du véhicule en une alimentation électrique adaptée à la réalisation d'une fonction lumineuse souhaitée, et éventuellement à fournir ladite alimentation électrique adaptée à une source électroluminescente pour la réalisation de ladite fonction lumineuse souhaitée.

Un circuit intégré, encore appelé puce électronique, est un composant électronique reproduisant une ou plusieurs fonctions électroniques et pouvant intégrer plusieurs types de composants électroniques de base, par exemple dans un volume réduit (i.e. sur une petite plaque). Cela rend le circuit facile à mettre en oeuvre.

Le circuit intégré peut être par exemple un ASIC ou un ASSP.

Un ASIC (acronyme de l'anglais « Application-Specific Integrated Circuit ») est un circuit intégré développé pour au moins une application spécifique (c'est-à-dire pour un client). Un ASIC est donc un circuit intégré (micro-électronique) spécialisé. En général, il regroupe un grand nombre de fonctionnalités uniques ou sur mesure.

Un ASSP (acronyme de l'anglais « Application Specific Standard Product ») est un circuit électronique intégré (micro-électronique) regroupant un grand nombre de fonctionnalités pour satisfaire à une application généralement standardisée. Un ASIC est conçu pour un besoin plus particulier (spécifique) qu'un ASSP

L'alimentation en électricité de la source électroluminescente, et donc des éléments électroluminescents est réalisée via le dispositif électronique, lui-même alimenté en électricité à l'aide par exemple d'au moins connecteur le reliant à une source d'électricité. Le dispositif électronique alimente alors les éléments électroluminescents en électricité. Le dispositif électronique est ainsi apte à commander les éléments électroluminescents.

Les modules lumineux des exemples des FIG. 1 et 2 comprennent chacun au moins dispositif 19, 229 de commande (encore appelé dispositif de pilotage) intégré au module lumineux. Dans ce cas de figure, le dispositif(s) électronique(s) 330 configure le ou les dispositifs de commande du module lumineux : il transmet une configuration au(x) dispositif(s) de commande du module lumineux afin qu'il pilote(nt) l'allumage d'un ou plusieurs éléments électroluminescents de la source. On comprend que le dispositif(s) électronique(s) 330 peut inversement transmettre une configuration au(x) dispositif(s) de commande du module lumineux afin qu'il(s) pilote(nt) l'extinction d'un ou plusieurs éléments électroluminescents de la source.

Lorsque le module lumineux ne comprend pas de dispositif 19, 229 de commande, le pilotage est réalisé directement par le dispositif électronique qui va configurer le ou les drivers de la source électroluminescente monolithique.

Ainsi, le dispositif électronique 330 est apte à commander directement les éléments électroluminescents de la source, ou alternativement il est apte à commander indirectement les éléments électroluminescents de la source en configurant le(s) dispositif(s) de commande du(des) module(s) lumineux, ou encore une combinaison de ces possibilités.

La configuration des éléments électroluminescents est réalisée en fonction de mesures reçues par le dispositif électronique 330, c'est-à-dire que le dispositif électronique détermine les éléments électroluminescents de la source électroluminescente monolithique devant être allumés en fonction de paramètres qu'il reçoit. Plus précisément, le dispositif électronique 330 reçoit des mesures de ces paramètres. Les mesures utilisées sont maintenant discutées.

Le dispositif électronique 330 est apte à recevoir des premières mesures concernant au moins un paramètre physique du véhicule. Un paramètre physique du véhicule est toute caractéristique mesurable du véhicule, et il évolue notamment lorsque le véhicule se déplace. Un paramètre physique du véhicule peut être, mais n'est pas limité à, la vitesse du véhicule, l'accélération du véhicule, l'angle de dérive des roues directrices (ou de la roue directrice) du véhicule, l'angle de roulis du véhicule, l'angle de tangage du véhicule, la géolocalisation du véhicule (coordonnées GPS ou tout autre système), la compression/décompression des suspensions du véhicule, l'activation d'une pédale de freinage, d'embrayage, d'accélération...

Le dispositif électronique 330 est apte également à recevoir des deuxièmes mesures qui concernent au moins un paramètre physique de la scène éclairée le système optique (302). Le paramètre physique de la scène peut être de la lumière émise par la scène, par exemple la lumière émise par une bande lumineuse blanche sur la route éclairée par le système optique 302 ou encore la lumière réfléchie et/ou émise par un autre véhicule, un lampadaire, un panneau de signalisation... Le paramètre physique de la scène peut également comprendre des informations cartographiques de cette dernière qui peuvent par exemple être fournies par un système de guide GPS. Ces informations cartographiques peuvent comprendre, amis ne sont pas limitées à, la courbure de la route, l'altitude, la présence d'une intersection, la présence d'une infrastructure (pont, tunnel,...)...

Le dispositif électronique 330 peut recevoir de manière synchrone les premières et/ou deuxièmes mesures. Il s'agit donc d'un mode de transmission à liaison synchrone, dans laquelle l'émetteur des mesures et le récepteur des mesures sont cadencés à une même horloge. Le récepteur reçoit de façon continue (même lorsque aucun bit n'est transmis) les informations au rythme où l'émetteur les envoie.

Alternativement, le dispositif électronique 330 peut recevoir de manière asynchrone les premières et/ou deuxièmes mesures. Il s'agit donc d'un mode de transmission à liaison asynchrone, dans laquelle l'émetteur des mesures envoie au récepteur les données des mesures et le signal d'horloge.

Une combinaison de ces modes de transmission peut être envisagée. Par exemple, le dispositif électronique 330 peut recevoir de manière synchrone les premières mesures et de manière asynchrone les deuxièmes mesures, ou bien l'inverse.

En pratique, les échanges d'informations auxquels participe le dispositif lumineux selon l'invention reposent sur des échanges asynchrones qui facilitent la gestion globale des transmissions et des calculs opérés par le dispositif électronique 330. Des échanges synchrones peuvent avoir également lieu, et bien que plus rapides, ils demandent de transmettre plus de données.

Les mesures des paramètres physiques reçues par le dispositif électronique 330 sont réalisées par des capteurs qui peuvent appartenir au dispositif, ou bien au contraire qui n'appartiennent pas au dispositif. Dans le premier cas, cela signifie que des capteurs doivent être installés sur le véhicule afin que le dispositif électronique puisse recevoir les mesures nécessaires à la bonne configuration des éléments électroluminescents de la source. Dans le deuxième cas, cela signifie que les capteurs déjà présents sur le véhicule sont mis à profit du dispositif selon l'invention : les capteurs sont raccordés au dispositif lumineux selon l'invention afin que le dispositif électronique puisse recevoir les mesures nécessaires à la bonne configuration des éléments électroluminescents de la source. Enfin, il est également possible de combiner ces deux cas, par exemple ajouter sur le véhicule un ou plusieurs capteurs qui sont ne sont pas installés sur ce dernier.

En pratique, un véhicule comprend de nombreux capteurs qui mesurent les paramètres physiques du véhicule, sans qu'il soit nécessaire d'en ajouter de supplémentaires, et le dispositif lumineux selon l'invention va donc de préférence exploiter les mesures faites par ces capteurs afin de ne pas complexifier la construction du véhicule. Par exemple, la vitesse du véhicule est continuellement mesurée par un capteur de vitesse qui la transmet à l'ordinateur de bord du véhicule, qui à son tour peut transmettre, par exemple de manière asynchrone, les valeurs mesurées au dispositif électronique 330. De même pour d'autres paramètres physiques du véhicule tels que son accélération, l'angle de dérive de ses roues directrices, son roulis, son tangage du véhicule, sa géolocalisation, la compression/décompression de ses suspensions du véhicule... Ainsi, il y a autant de de types de premières mesures qu'il y a de types de capteurs de paramètres physique du véhicule. De préférence, le dispositif selon l'invention connaît avec précision l'orientation du véhicule à l'aide d'information concernant (i) l'angle de tangage du véhicule qui peut être fournis par des capteurs d'accélération, de décélération, de freinage, de suspensions, et (ii) concernant l'angle de roulis du véhicule qui peut être fourni par des capteurs mesurant l'angle des roues directrices ou l'angle du volant ou la vitesse du véhicule ou les accélérations latérales.

Concernant les paramètres physiques de la scène, ceux-ci peuvent être capturés par une caméra 310 disposée sur le véhicule, et/ou par une caméra infra-rouge, et/ou un radar, et/ou un télédétecteur par radar (LIDAR en anglais). La caméra infrarouge, le radar et le lidar permettent de détecter des objets non réfléchissants tels que par exemple des piétons ou des animaux. La caméra produit un flux d'images, par exemple de vingt-cinq à trente images par seconde. Chaque image produite par la caméra capture la luminosité des objets présents dans la scène éclairée. La caméra, en tant que capteur, peut être associée à une unité d'analyse 312 du flux d'images qu'elle produit. En effet, les images comportent un nombre très important d'information dont le traitement peut être trop lourd pour le dispositif électronique 330. L'unité d'analyse 312 extrait les informations pertinentes pour chaque image du flux d'images produit par la caméra, à l'aide par exemple d'algorithmes de traitement d'image. Dans le contexte d'un dispositif lumineux de véhicule terrestre, les informations pertinent peuvent être, mais ne sont pas limités à, la détection d'objets tels qu'un véhicule venant de face, un usager de la route (moto, cycliste,...), un piéton, un animal, la signalisation routière telle que les lignes de marquage, les panneaux de signalisation... Les données contenues dans les images peuvent donc être segmentées et catégorisées afin de permettre au dispositif électronique de connaître quels sont les objets présents et quelle est la localisation de chacun des objets par rapport au véhicule. La segmentation d'image est une opération de traitement d'images qui a pour but de rassembler des pixels entre eux suivant des critères prédéfinis. Les pixels sont ainsi regroupés en régions, qui constituent un pavage ou une partition de l'image. Par exemple, une première segmentation d'un véhicule en déplacement peut être basée sur la détection de ces feux avant ou de ces feux arrière. Dépendant de la nature de l'objet, de ses dimensions et de sa localisation par rapport au véhicule, le dispositif électronique déterminera s'il faut l'éclairer ou pas, ou encore avec quelle intensité l'éclairer.

Les paramètres physiques peuvent également être mesurés par des capteurs qui ne sont pas disposés sur le véhicule. Par exemple, des informations concernant la signalisation routière peuvent être transmises au véhicule par des bornes situées à proximité de la route. Ou encore, les informations concernant la circulation (par exemple un danger sur le trajet du véhicule) peuvent être transmises via un système de télécommunication tel qu'un réseau de télécommunication mobile.

Toujours pour éviter des calculs au dispositif électronique 330, l'unité d'analyse 312 peut aussi utiliser les résultats de segmentation précédemment calculés pour réaliser une prédiction sur la nature des objets présents et leur localisation. Des filtres prédictifs d'analyse d'image peuvent être utilisés, par exemple un filtre de Kalman, un filtre particulaire.

On comprend que lorsque la caméra comprend une unité d'analyse 312, c'est cette dernière qui transmet au dispositif électronique 330 les mesures effectuées - dans ce cas, il s'agit plus précisément des informations qui ont été extraites des images produites par la caméra-.

Comme discuté précédemment, la transmission des informations est réalisée de préférence de manière asynchrone ; une transmission synchrone est cependant envisageable. La transmission se réalise à l'aide d'un ou plusieurs BUS de communication, par exemple en utilisant les BUS de communication déjà présents dans le véhicule. Bien entendu, tout type de BUS de communication est envisageable, mais une transmission filaire est privilégiée pour des raisons de rapidité et fiabilité de la transmission. Ainsi un système de bus série asynchrone CAN (acronyme anglais de « Controller Area Network ») normalisé avec la norme ISO 11898 peut être utilisé.

En pratique, chacun des capteurs mesurant un paramètre physique du véhicule est en mesure de fournir plus fréquemment une mesure que la caméra : en effet, l'analyse des images produites par la caméra implique des traitements qui requièrent de nombreux calculs qui prennent plus de temps qu'une simple acquisition d'une valeur d'un paramètre physique. Par exemple, la fréquence de rafraichissement des capteurs mesurant les paramètres physiques du véhicule peut être aux alentours de 100-200 Hertz (Hz), alors que celle de la caméra peut être trois fois inférieure (soit aux alentours de 25-30Hz). De préférence, la fréquence de rafraichissement des capteurs mesurant les paramètres physiques du véhicule est de 20 Hz, et la fréquence de rafraichissement des capteurs mesurant les paramètres de la scène est de 5 Hz. Dit autrement, le dispositif électronique peut recevoir au moins trois fois plus de mesures par capteur des paramètres physiques du véhicule et par unité de temps que des paramètres physiques de la scène capturés à l'aide d'une caméra. Ainsi, les mesures des paramètres physiques du véhicule peuvent être utilisées par le dispositif électronique pour configurer les éléments électroluminescents et les mesures obtenues par la caméra peuvent être utilisées pour corriger, si besoins est, les configurations obtenues avec les mesures des paramètres physiques. De plus, la fréquence de rafraichissement supérieure des mesures des paramètres physiques permet de commander rapidement l'allumage ou l'extinction des éléments de la source.

En outre, il peut être possible pour le dispositif électronique de ne pas rafraîchir la configuration des éléments électroluminescent de la source à chaque nouvelle arrivée de mesures reçues afin diminuer le nombre de configurations devant être transmises au(x) dispositif(s) de commande du module lumineux.

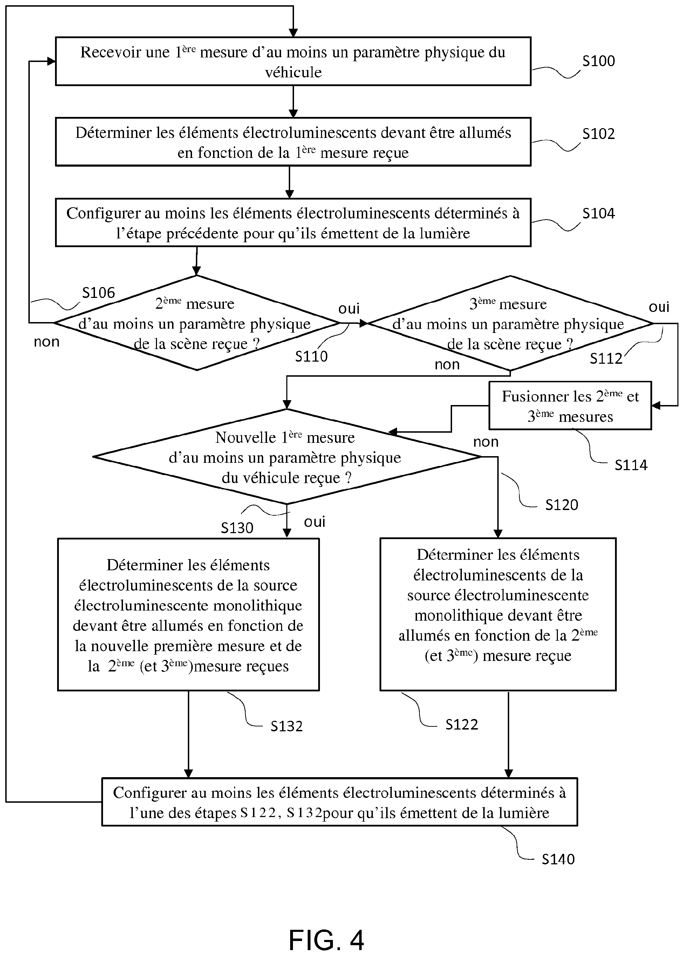

Il est maintenant discuté un exemple de procédé pour illuminer une scène avec le dispositif lumineux selon l'invention. La discussion est faite en référence à l'ordinogramme de la FIG. 4. Dans cet exemple, au moins un élément électroluminescent du dispositif lumineux est allumé avant la réalisation de la première étape du procédé, étant entendu que ce même procédé pourrait s'appliquer avec la source électroluminescente éteinte avant la réalisation de la première étape du procédé.

A l'étape S100, le dispositif électronique reçoit au moins une première mesure d'au moins un paramètre physique du véhicule. En pratique, chaque capteur transmet une mesure dès qu'elle a été acquise via un moyen adéquat, par exemple un BUS de communication asynchrone le reliant au dispositif électronique.

A l'étape S102, le dispositif électronique détermine les éléments électroluminescents devant être allumés en fonction d'une ou des mesures des paramètres physiques du véhicule reçues.

Ensuite, à l'étape S104, le dispositif électronique détermine les éléments électroluminescents devant être allumés en fonction d'une ou des mesures reçues. Cette étape peut être réalisée dès qu'une nouvelle mesure lui parvient, ou bien il peut attendre d'avoir reçu au moins une mesure de chacun des capteurs. Une autre possibilité est que le dispositif électronique fasse la détermination à une fréquence donnée, et ce indépendamment du fait ait reçu ou non une nouvelle mesure de tout ou partie des capteurs présents.

Une configuration des éléments électroluminescents devant être allumé est obtenue qui est envoyée au(x) driver(s) de la source électroluminescente monolithique pour exécution. L'éclairage du véhicule est modifié si les mesures rapportées par les capteurs des paramètres physiques du véhicule rendent une correction nécessaire.

Tant qu'aucune mesure d'un paramètre physique de la scène n'est parvenue au dispositif électronique 330 (S106), les étapes S100, S102, S104 sont répétées de sorte que l'éclairage est configuré en fonction des paramètres physiques du véhicule uniquement.

A l'étape S110, le dispositif électronique reçoit au moins une deuxième mesure d'au moins un paramètre physique de la scène. Par exemple, l'unité d'analyse 312 envoie le résultat des analyse d'une ou plusieurs images du flux d'images généré par la caméra.

Si le dispositif comprend plusieurs capteurs capturant des paramètres physiques de la scène différents, par exemple une caméra pour identifier les objets réfléchissants et une caméra infrarouge pour identifier les objets non-réfléchissants, le dispositif électronique peut recevoir au moins une troisième mesure d'au moins un paramètre physique de la scène (étape S112) différent de celui de la deuxième mesure. Par exemple, une caméra peut avoir apporté la deuxième mesure et une caméra infra-rouge une troisième mesure. Dans ce cas, les deuxièmes et troisièmes mesures sont fusionnées (étape S114) afin de fournir une information sur les paramètres physique de la scène qui est consolidée.

A l'étape S122, le dispositif électronique détermine les éléments électroluminescents devant être allumés en fonction de la deuxième mesure reçue ou bien en fonction des deuxièmes et troisièmes mesures fusionnées. Dans cette étape S122, il n'y a pas eu de nouvelles mesures rapportées par les capteurs des paramètres physiques du véhicule (étape S120) après que l'étape S110 ou S114 ait été réalisée. Une correction est alors appliquée à l'aide des informations récupérées par la caméra sur la précédente configuration calculée à partir des premières mesures.

Alternativement, une étape S132 peut être réalisée dans laquelle le dispositif électronique détermine les éléments électroluminescents devant être allumés en fonction de la deuxième mesure reçue - ou bien en fonction des deuxièmes et troisièmes mesures fusionnées- et en fonction de nouvelles mesures rapportées par les capteurs des paramètres physiques du véhicule qui sont parvenues (étape S130) au dispositif électronique après que l'étape S110 ou S114 ait été réalisée, c'est-à-dire après qu'une deuxième mesure ou une troisième mesure ait été reçue.

La nouvelle configuration des éléments électroluminescents devant être allumé est transmise à son tour au(x) driver(s) de la source électroluminescente monolithique pour exécution, à l'étape S140. L'éclairage produit par la source lumineuse est modifié.

Le procédé est répété à partir de l'étape S100 et ce jusqu'à ce qu'il n'y ait plus besoin que dispositif lumineux éclaire la scène, par exemple la luminosité de la scène captée par la caméra est jugée comme adaptée par le dispositif électronique.

## Revendications

1. Dispositif lumineux (30) de véhicule terrestre pour éclairer une scène (32), comprenant :
- une source électroluminescente monolithique (304) comprenant des éléments électroluminescents ;
- un système optique (302) agencé pour former une image de la source électroluminescente monolithique pour éclairer la scène (32) ;
- un dispositif électronique (330) apte à :
-- recevoir au moins une première mesure à une première fréquence concernant au moins un paramètre physique du véhicule terrestre ;
-- recevoir au moins une deuxième mesure à une deuxième fréquence concernant au moins un paramètre physique de la scène; et
-- commander les éléments électroluminescents de la source électroluminescente monolithique (304) en fonction des premières et/ou deuxièmes mesures reçues
**caractérisé en ce que** la première fréquence est supérieure à la deuxième fréquence ;
et **en ce que** les éléments électroluminescents de la source électroluminescente monolithique sont commandés en fonction des premières mesures reçues tant que la deuxième mesure n'a pas été reçue.

2. Dispositif lumineux selon la revendication 1, dans lequel le dispositif électronique comprend au moins un convertisseur de puissance (308) et/ou un circuit intégré.

3. Dispositif lumineux selon l'une des revendications 1 à 2, dans lequel la fréquence de réception des premières mesures est au moins trois fois supérieure à celle des deuxièmes mesures.

4. Dispositif lumineux selon l'une des revendications 1 à 3, comprenant en outre au moins un premier capteur (320) générant les premières mesures.

5. Dispositif lumineux selon l'une des revendications 1 à 4, comprenant en outre au moins un deuxième capteur (310, 312) générant les deuxièmes mesures.

6. Dispositif lumineux selon la revendication 5, dans lequel le deuxième capteur est une caméra (310) produisant un flux d'images.

7. Dispositif lumineux selon la revendication 6, dans lequel le deuxième capteur (312) comprend en outre une unité d'analyse du flux d'images produit par la caméra.

8. Dispositif lumineux selon la revendication 7, dans lequel l'unité d'analyse réalise des opérations de segmentations des images du flux d'images.

9. Dispositif lumineux selon l'une des revendications 1 à 8, comprenant en outre un dissipateur thermique agencé sur au moins la source électroluminescente monolithique.

10. Dispositif lumineux selon l'une des revendications 1 à 9, dans lequel le système optique a une résolution qui est inférieure ou égale à 0.25 degrés et un champ supérieur ou égale à 5 degrés.

11. Procédé pour illuminer une scène (32) avec le dispositif lumineux selon l'une des revendications 1 à 10, comprenant les étapes consistant à :
(i) recevoir (S100), au niveau du dispositif électronique, une première mesure d'au moins un paramètre physique du véhicule à une première fréquence ;
(ii) déterminer (S102), par le dispositif électronique, les éléments électroluminescents de la source électroluminescente monolithique devant être allumés en fonction de la première mesure reçue ;
(iii) configurer (S104), par le dispositif électronique, au moins les éléments électroluminescents déterminés à l'étape (ii) pour qu'ils émettent de la lumière ; dans lequel les étapes (i), (ii), (iii) sont répétées (S106) tant qu'une deuxième mesure d'un paramètre physique de la scène n'a pas été reçue, la deuxième mesure étant reçue à une deuxième fréquence, la première fréquence étant supérieure à la deuxième fréquence.

12. Procédé selon la revendication 11, comprenant en outre, après l'étape (iii), les étapes consistant à :
(iv) recevoir (S110), au niveau du dispositif électronique, la deuxième mesure d'au moins un paramètre physique de la scène à la deuxième fréquence;
(v) déterminer (S122), par le dispositif électronique, les éléments électroluminescents de la source électroluminescente monolithique devant être allumés en fonction de la deuxième mesure reçue ;
(vi) configurer (S140), par le dispositif électronique, au moins les éléments électroluminescents déterminés à l'étape (v) pour qu'ils émettent de la lumière.

13. Procédé selon la revendication 11, comprenant en outre, après l'étape (iii), les étapes consistant à :
(iv) recevoir, au niveau du dispositif électronique, la deuxième (S110) et une troisième (S112) mesures d'au moins deux paramètres physiques de la scène ;
(v) fusionner (S114) les deuxième et troisième mesures reçues ;
(vi) recevoir (S130), au niveau du dispositif électronique, une nouvelle première mesure d'au moins un paramètre physique du véhicule ;
(vii) déterminer (S132), par le dispositif électronique, les éléments électroluminescents de la source électroluminescente monolithique devant être allumés en fonction de la nouvelle première mesure reçue et des deuxième et troisième mesures reçues ;
(viii) configurer (S140), par le dispositif électronique, au moins les éléments électroluminescents déterminés à l'étape (vii) pour qu'ils émettent de la lumière.

## Patentansprüche

1. Leuchtvorrichtung (30) für ein Landfahrzeug, um eine Szene (32) zu beleuchten, umfassend:
- eine monolithische lichtemittierende Quelle (304), die lichtemittierende Elemente umfasst;
- ein optisches System (302), das dazu eingerichtet ist, ein Bild der monolithischen lichtemittierenden Quelle zu bilden, um die Szene (32) zu beleuchten;
- eine elektronische Vorrichtung (330), die geeignet ist:
- mindestens eine erste Messung mit einer ersten Frequenz bezüglich mindestens eines physikalischen Parameters des Landfahrzeugs zu empfangen;
- mindestens eine zweite Messung mit einer zweiten Frequenz bezüglich mindestens eines physikalischen Parameters der Szene zu empfangen; und
- die lichtemittierenden Elemente der monolithischen lichtemittierenden Quelle (304) in Abhängigkeit von den empfangenen ersten und/oder zweiten Messungen zu steuern, **dadurch gekennzeichnet, dass** die erste Frequenz höher als die zweite Frequenz ist;
und dass die lichtemittierenden Elemente der monolithischen lichtemittierenden Quelle in Abhängigkeit von den empfangenen ersten Messungen gesteuert werden, solange die zweite Messung nicht empfangen worden ist.

2. Leuchtvorrichtung nach Anspruch 1, bei der die elektronische Vorrichtung mindestens einen Leistungswandler (308) und/oder eine integrierte Schaltung umfasst.

3. Leuchtvorrichtung nach einem der Ansprüche 1 bis 2, bei der die Empfangsfrequenz der ersten Messungen mindestens dreimal so hoch wie die der zweiten Messungen ist.

4. Leuchtvorrichtung nach einem der Ansprüche 1 bis 3, umfassend ferner mindestens einen ersten Sensor (320), der die ersten Messungen erzeugt.

5. Leuchtvorrichtung nach einem der Ansprüche 1 bis 4, umfassend ferner mindestens einen zweiten Sensor (310, 312), der die zweiten Messungen erzeugt.

6. Leuchtvorrichtung nach Anspruch 5, bei welcher der zweite Sensor eine Kamera (310) ist, die einen Bilderstrom produziert.

7. Leuchtvorrichtung nach Anspruch 6, bei welcher der zweite Sensor (312) ferner eine Analyseeinheit zur Analyse des von der Kamera produzierten Bilderstroms umfasst.

8. Leuchtvorrichtung nach Anspruch 7, bei welcher die Analyseeinheit Vorgänge zur Segmentierung der Bilder des Bilderstroms ausführt.

9. Leuchtvorrichtung nach einem der Ansprüche 1 bis 8, umfassend ferner einen Wärmeableiter, der mindestens auf der monolithischen lichtemittierenden Quelle angeordnet ist.

10. Leuchtvorrichtung nach einem der Ansprüche 1 bis 9, bei der das optische System eine Auflösung, die kleiner als oder gleich 0,25 Grad ist, und einen Bereich größer oder gleich 5 Grad hat.

11. Verfahren zum Beleuchten einer Szene (32) mit der Leuchtvorrichtung nach einem der Ansprüche 1 bis 10, umfassend die folgenden Schritte:
(i) Empfangen (S100), an der elektronischen Vorrichtung, einer ersten Messung mindestens eines physikalischen Parameters des Fahrzeugs mit einer ersten Frequenz;
(ii) Bestimmen (S102), durch die elektronische Vorrichtung, der lichtemittierenden Elemente der monolithischen lichtemittierenden Quelle, die eingeschaltet werden müssen, in Abhängigkeit von der empfangenen ersten Messung;
(iii) Konfigurieren (S104), durch die elektronische Vorrichtung, mindestens der im Schritt (ii) bestimmten lichtemittierenden Elemente, damit sie Licht aussenden; wobei die Schritte (i), (ii), (iii) wiederholt werden (S106), solange eine zweite Messung eines physikalischen Parameters der Szene nicht empfangen worden ist, wobei die zweite Messung mit einer zweiten Frequenz empfangen wird, wobei die erste Frequenz höher als die zweite Frequenz ist.

12. Verfahren nach Anspruch 11, umfassend ferner, nach dem Schritt (iii), die folgenden Schritte:
(iv) Empfangen (S110), an der elektronischen Vorrichtung, der zweiten Messung mindestens eines physikalischen Parameters der Szene mit der zweiten Frequenz;
(v) Bestimmen (S122), durch die elektronische Vorrichtung, der lichtemittierenden Elemente der monolithischen lichtemittierenden Quelle, die eingeschaltet werden müssen, in Abhängigkeit von der empfangenen zweiten Messung;
(vi) Konfigurieren (S140), durch die elektronische Vorrichtung, mindestens der im Schritt (v) bestimmten lichtemittierenden Elemente, damit sie Licht aussenden.

13. Verfahren nach Anspruch 11, umfassend ferner, nach dem Schritt (iii), die folgenden Schritte:
(iv) Empfangen, an der elektronischen Vorrichtung, der zweiten (S110) und einer dritten (S112) Messung von mindestens zwei physikalischen Parametern der Szene;
(v) Zusammenführen (S114) der empfangenen zweiten und dritten Messungen;
(vi) Empfangen (S130), an der elektronischen Vorrichtung, einer neuen ersten Messung mindestens eines physikalischen Parameters des Fahrzeugs;
(vii) Bestimmen (S132), durch die elektronische Vorrichtung, der lichtemittierenden Elemente der monolithischen lichtemittierenden Quelle, die eingeschaltet werden müssen, in Abhängigkeit von der empfangenen neuen ersten Messung und von den empfangenen zweiten und dritten Messungen;
(viii) Konfigurieren (S140), durch die elektronische Vorrichtung, mindestens der im Schritt (vii) bestimmten lichtemittierenden Elemente, damit sie Licht aussenden.

## Claims

1. Luminous land-vehicle device for illuminating a scene, comprising:
- a monolithic electroluminescent source (304) comprising electroluminescent elements;
- an optical system (302) arranged to form an image of the monolithic electroluminescent source;
- an electronic device (330) able to:
-- receive at least one first measurement at a first frequency regarding at least one physical parameter of the vehicle;
-- receive at least one second measurement at a second frequency regarding at least one physical parameter of the scene; and
-- control the electroluminescent elements of the monolithic electroluminescent source (304) depending on the received first and/or second measurements
**characterized in that** the first frequency is greater than the second frequency;
and **in that** the electroluminescent elements of the monolithic electroluminescent source are controlled depending on the first measurement received as long as the second measurement has not been received.

2. Luminous device according to Claim 1, wherein the electronic device comprises at least one power converter (308) and/or one integrated circuit.

3. Luminous device according to one of Claims 1 to 2, wherein the reception frequency of the first measurements is at least three times higher than that of the second measurements.

4. Luminous device according to one of Claims 1 to 3, furthermore comprising at least one first sensor (320) that generates the first measurements.

5. Luminous device according to one of Claims 1 to 4, furthermore comprising at least one second sensor (310, 312) that generates the second measurements.

6. Luminous device according to Claim 5, wherein the second sensor is a camera (310) that produces an image stream.

7. Luminous device according to Claim 6, wherein the second sensor (312) furthermore comprises a unit for analyzing the image stream produced by the camera.

8. Luminous device according to Claim 7, wherein the analyzing unit carries out segmenting operations on the images of the image stream.

9. Luminous device according to one of Claims 1 to 8, furthermore comprising a heatsink arranged on at least the monolithic electroluminescent source.

10. Luminous device according to one of Claims 1 to 9, wherein the optical system has a resolution that is lower than or equal to 0.25 degrees and a field larger than or equal to 5 degrees.

11. Method for illuminating a scene with the luminous device according to one of Claims 1 to 10, comprising steps in which:
(i) the electronic device receives (S100) a first measurement of at least one physical parameter of the vehicle;
(ii) the electronic device determines (S102) which electroluminescent elements of the monolithic electroluminescent source must be turned on depending on the received first measurement;
(iii) the electronic device configures (S104) at least the electroluminescent elements determined in step (ii) so that they emit light wherein steps (i), (ii), (iii) are repeated (S106) as long as a second measurement of a physical parameter of the scene has not been received, the second measurement being received at a second frequency, the first frequency being greater than the second frequency.

12. Method according to Claim 11, furthermore comprising, after step (iii), steps in which:
(iv) the electronic device receives (S110) a second measurement of at least one physical parameter of the scene at a second frequency;
(v) the electronic device determines (S122) which electroluminescent elements of the monolithic electroluminescent source must be turned on depending on the received second measurement;
(vi) the electronic device configures (S140) at least the electroluminescent elements determined in step (v) so that they emit light.

13. Method according to Claim 11, furthermore comprising, after step (iii), steps in which:
(iv) the electronic device receives (S110, S112) second and third measurements of at least two physical parameters of the scene;
(v) the received second and third measurements are fused (S114);
(vi) the electronic device receives (S130) a new first measurement of at least one physical parameter of the vehicle;
(vii) the electronic device determines (S132) which electroluminescent elements of the monolithic electroluminescent source must be turned on depending on the received new first measurement and the received second and third measurements;
(viii) the electronic device configures (S140) at least the electroluminescent elements determined in step (vii) so that they emit light.
